(19) **Europäisches Patentamt**
**European Patent Office**
**Office européen des brevets**

(11) **EP 1 820 211 B1**

(12) **EUROPEAN PATENT SPECIFICATION**

(45) Date of publication and mention of the grant of the patent:
**01.08.2012 Bulletin 2012/31**

(51) Int Cl.:
*H01L 21/28* (2006.01)  *H01L 29/78* (2006.01)
*H01L 29/10* (2006.01)

(21) Application number: **05848845.3**

(22) Date of filing: **06.12.2005**

(86) International application number:
**PCT/US2005/043841**

(87) International publication number:
**WO 2006/062869 (15.06.2006 Gazette 2006/24)**

(54) **GATE ENGINEERED FERMI-FETS WITH STRAINED SILICON CHANNEL AND MANUFACTURING METHOD**

FERMI-FETS MIT TECHNISIERTEM GATE UND VERSPANNTEM SILIZIUMKANAL UND HERSTELLUNGSVERFAHREN

TRANSISTORS A EFFET DE CHAMP DE FERMI A GRILLE ELABORE, AVEC UN CANAL DE SILICIUM CONTRAINT ET PROCEDE DE FABRICATION

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.12.2004 US 634016 P**

(43) Date of publication of application:
**22.08.2007 Bulletin 2007/34**

(73) Proprietor: **Thunderbird Technologies, Inc.**
**Morrisville NC 27560 (US)**

(72) Inventors:
• **RICHARDS, William, R., Jr.**
**Cary, NC 27615 (US)**
• **SHEN, Mike, Yen-chao**
**Apt 626 B Austin, TX 78758 (US)**

(74) Representative: **Horner, Martin Grenville**
**Marks & Clerk LLP**
**Aurora**
**120 Bothwell Street**
**Glasgow**
**G2 7JS (GB)**

(56) References cited:
**WO-A-98/13880**  **US-A1- 2004 219 726**
**US-A1- 2004 222 443**  **US-B1- 6 373 112**
**US-B1- 6 555 872**

• **"SI/SIGE HETEROSTRUCTURE MOS DEVICES WITH STEP-GRADED BANDGAP PROFILE OF THE SIGE CHANNEL" IBM TECHNICAL DISCLOSURE BULLETIN, IBM CORP. NEW YORK, US, vol. 36, no. 3, 1 March 1993 (1993-03-01), pages 127-129, XP000354724 ISSN: 0018-8689**

EP 1 820 211 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field of the Invention**

The invention relates to semiconductor devices and fabrication methods, and more particularly to field effect transistors (FETs) and fabrication methods therefor.

**Background of the Invention**

Fermi-FET devices have been well-explored by Thunderbird Technologies, the assignee of the present invention, and others for a number of years. Fermi-FET transistors are described in the following U.S. Patents 4,984,043; 4,990,974; 5,151,759; 5,194,923; 5,222,039; 5,367,186; 5,369,295; 5,371,396; 5,374,836; 5,438,007; 5,440,160; 5,525,822; 5,543,654; 5,698,884; 5,786,620; 5,814,869; 5,885,876; and 6,555,872

At coarser geometries, the supply voltage can be high enough to allow the use of degenerately-doped polysilicon gates for the *n* and *p*-channel Fermi-FET devices. For more deeply scaled CMOS technologies, a mid-bandgap gate material may be used to provide device threshold voltages that can be more suitable for device operation, whether for high-performance (low $V_T$) or low-power (higher $V_T$) applications. See, for example, U.S. Patent 5,952,701. This is because the channel engineering of the Fermi-FET can use specific doping profiles in order to realize the low-field benefits of the device design. A device designer can balance the subthreshold behavior, including $I_{OFF}$, subthreshold slope $S$, drain-induced barrier lowering (*DIBL*) and $V_T$ roll-off vs. the performance, including $I_{DSAT}$ (the off vs. on-current) and capacitances given the technology constraints of the gate stack, oxide thickness $t_{ox}$, foundry tool sets, etc. and product requirements.

**Summary of the Invention**

Field effect transistors according to exemplary embodiments of the present invention include a strained silicon channel in a substrate, source/drain regions in the substrate at opposite ends of the strained silicon channel, a gate insulating layer on the strained silicon channel, and a gate on the gate insulating layer. The doping of the strained silicon channel, the doping of the substrate and/or the depth of the strained silicon channel are configured to produce nearly zero vertical electric field in the gate insulating layer and in the strained silicon channel adjacent thereto at a threshold voltage of the field effect transistor. Moreover, the gate is configured to provide a gate work function that is close to a mid-bandgap of silicon. Accordingly, a Fermi-FET with a strained silicon channel and a gate with a mid-bandgap work function may be provided.

In some embodiments, a relaxed silicon-germanium buffer layer is provided between the substrate and the strained silicon channel. The relaxed silicon-germanium buffer layer is configured to apply strain to the strained silicon channel. Moreover, in some embodiments, the gate comprises polysilicon-germanium. In other embodiments, a polysilicon layer also may be provided on the polysilicon-germanium remote from the gate insulating layer.

In some embodiments, the gate is configured to provide a gate work function that is within about 0.3 eV of the mid-bandgap of silicon. Moreover, in other embodiments, the gate is configured to provide a gate work function of about 4.7 eV.

In other embodiments, the doping of the channel, the doping of the substrate and/or the depth of the channel are selected according to

$$x_i = \frac{N_A}{N_D + N_A} \sqrt{\frac{2\varepsilon_s}{q} \left[\left[\frac{1}{N_A} + \frac{1}{N_D}\right]\right]},$$

wherein $x_i$ is the depth of the channel, $N_A$ is the substrate doping, $N_D$ is the channel doping, $\varepsilon_s$ is the permittivity of silicon, and q is the elementary charge.

It will be understood by those having skill in the art that embodiments of the invention have been described above as including a Fermi-FET having nearly zero vertical electric field at threshold, combined with a strained silicon channel and a mid-bandgap gate. In other embodiments, subcombinations of these elements also may be provided. Thus, in some embodiments, a Fermi-FET may be provided with a strained silicon channel and a gate that is configured to provide a gate work function that is not close to the mid-bandgap of silicon. In other embodiments, a Fermi-FET may be provided with a gate that is configured to provide a gate work function that is close to the mid-bandgap of silicon, and that includes a channel that is not strained. In still other embodiments, conventional MOSFETs that are not Fermi-FETs may be provided with a strained silicon channel and with a mid-bandgap gate.

Field effect transistors may be fabricated according to exemplary embodiments of the present invention by epitaxially growing a relaxed silicon-germanium buffer on a substrate, epitaxially growing a strained silicon channel on the relaxed silicon-germanium buffer layer, and forming source/drain regions in the substrate at opposite ends of the strained silicon channel. A gate insulating layer is formed on the strained silicon channel, and a gate that is configured to provide a gate work function that is close to a mid-bandgap of silicon is formed thereon. The doping of the strained silicon channel, the doping of the substrate and/or the depth of the strained silicon channel may be configured to produce nearly zero vertical electric field in the gate insulating layer and in the strained silicon channel adjacent thereto at a threshold voltage of the field effect transistor. In some embodiments, the source/drain regions are formed by selective epitaxial growth while epitaxially growing the relaxed silicon-germanium buffer layer and/or the strained silicon channel.

## Brief Description of the Drawings

Figure 1 graphically illustrates work function as a function of germanium content in silicon-germanium.

Figure 2 graphically illustrates relative mobility enhancement for holes and electrons in silicon-germanium compared to silicon.

Figure 3 graphically illustrates channel doping profile in the center of a channel for both conventional MOSFETs and Fermi-FET devices.

Figure 4 graphically illustrates transverse field profiles in the center of the channel for conventional MOSFETs and Fermi-FET devices.

Figure 5 graphically illustrates lateral profiles of transverse fields in the gate insulator (oxide) for both conventional MOSFETs and Fermi-FET devices.

Figure 6 graphically illustrates the lateral profiles of transverse fields at the substrate surface along the device channels at the surface for both conventional MOSFETs and Fermi-FET devices.

Figure 7 is a cross-sectional illustration of a strained silicon on silicon-germanium, silicon-germanium gate Fermi-FET according to exemplary embodiments of the present invention.

Figure 8 is a diagram of a one-dimensional channel structure defining the doping distributions and depletion regions at the threshold voltage of the transistor of Figure 7.

## Detailed Description

### Gate Engineering

For Deep Sub-Micron (DSM) Fermi-FETs, it may be desirable to have the flexibility of setting or tuning the gate work function independent of other device characteristics. For example, the gate work function may be independent of the substrate dopings, gate oxide thickness and device geometry. With this capability, the $n$ and $p$-channel gate materials could be tuned separately, allowing the $n$ and $p$-channel device threshold voltages to be set independently of each other. In practice, however, this capability may be expensive, because it may use true metal gates with the capability of selectively altering the work function (for example using photolithography).

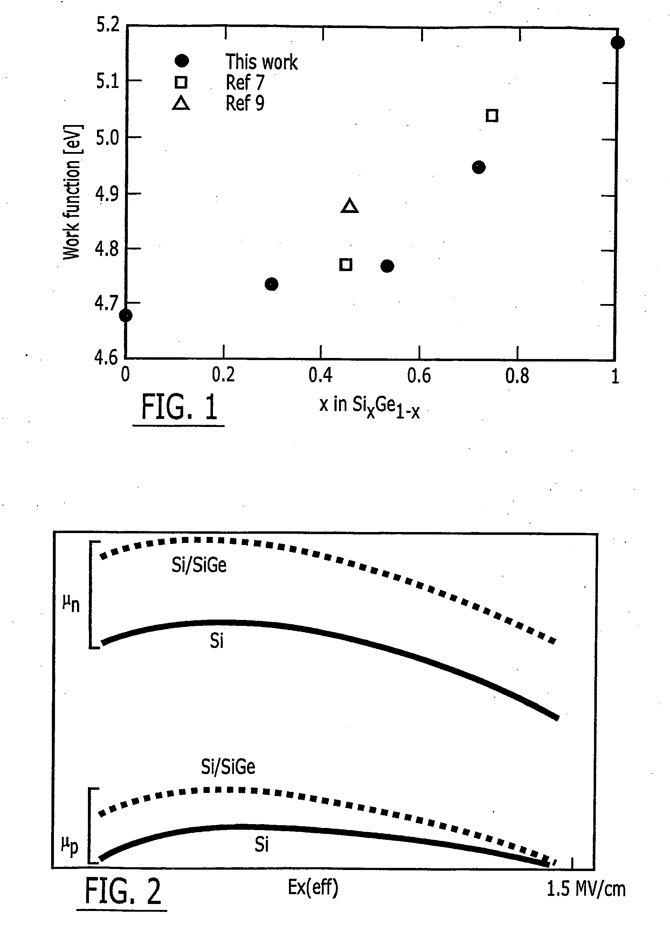

It is known to use $Si_{1-x}Ge_x$ gate in a conventional MOSFET, where the gate stack may be a layered arrangement of polysilicon on top of a deposited polysilicon incorporating Ge. A buffer layer of amorphous Si may also be used at the bottom of the stack, which ends up recrystallizing with the Ge content. See, for example, Hellberg et al. "Work Function of Boron-Doped Polycrystalline SixGe1-x Films," IEEE Electron Device Letters, Vol. 18, No. 9, Sept. 1997, pp. 456-458. The Ge content causes a narrowing of the bandgap, leading to a shift in the work function. When the gate is degenerately doped $p$-type, work function shifts up to 400 mV have been reported in Hellberg et al. Figure 1 is a reproduction of work function shifts as a function of the Si content as reported in Hellberg et al. Note that this figure shows work function as a function of $Si$, not $Ge$ content, as is currently customary. Moreover, Ref 7 and Ref 9 in the legend refer to references from Hellberg et al. The electron affinity of the poly-$Si_{1-x}Ge_x$ gate is very close to the affinity of pure Si. When the gate stack is degenerately doped $p$-type, near the valence band edge, the shift in Fermi level due to the bandgap narrowing results in the work function shift. Practical values of Ge content can result in work functions of about 4.9 eV. Note that experimental values of work function may differ from the data shown in Figure 1. An example gate structure could have Ge content in the poly-$Si_{1-x}Ge_x$ layer of 50-70% (mole fraction) and be doped with a boron dose of $10^{15}$ cm$^{-3}$.

For Fermi-FET designs, it may be desirable to have a work function close to the midgap level of 4.72 eV, for example, due to low power supplies such as $V_{DD}=1.2$ V. Logic design typically uses a $V_{DD}/V_T$ ratio of at least 3.5-4, meaning a $V_T$ of no more than 0.3-0.4 V may be desirable. Fermi-FET designs with a true mid-bandgap work function of around 4.7 eV can provide a $V_T$ of about 0.4 V. Considering only the $n$-channel device, a SiGe gate work function of 4.9 eV is too high, however, since the $V_T$ will be around 0.6 V. Thus, a SiGe gate work function may make it difficult to design low-field Fermi-FET devices, because the resulting $V_T$ values may generally be too high.

## Substrate Engineering

Relatively recently, work has taken place on the effects of lattice strain in both the substrate and gates of CMOS technology. See, Fossum et al., "Performance Projections of Scaled CMOS Devices and Circuits With Strained Si-on-SiGe Channels," IEEE Transactions on Electron Devices, Vol. 50, No. 4, April, 2003, pp. 1042-1049, and Miyata et al., "Electron transport properties of a strained Si layer on a relaxed Si1-xGex substrate by Monte Carlo simulation," Applied Physics Letters, Vol. 62, No. 21, May, 1993, pp. 2661-2663. The application of tensile or compressive stress to the substrate of a CMOS wafer can have profound effects on the performance of the devices. The most notable effect may be that of mobility enhancement, both in the bulk and at the surface. The applied strain generally reduces the bandgap in the affected region, which can alter the effective masses of the charge carriers, and can lead to higher velocities (and mobility). In addition, the deleterious effects of phonon scattering and surface roughness may be reduced with applied strain. The literature has reported significant mobility enhancements of up to 45% for n-channel MOSFETs. See, Goo et al., "Scalability of Strained-Si nMOSFETs Down to 25 nm Gate Length," IEEE Electron Device Letters, Vol. 24, No. 5, May, 2003, pp. 351-353.

One method to achieve the desired strain is to use an epitaxial $Si/Si_{1-x}Ge_x$ heterostructure, so-called bandgap engineering. A significant amount of research in this area has already taken place. Recent work has taken place devoted to understanding the physics involved and developing practical models suitable for device and circuit design, as noted in the above-cited Fossum et al. and Miyata et al. publications, and in Lim et al., "Comparison of Threshold-Voltage Shifts for Uniaxial and Biaxial Tensile-Stressed n-MOSFETs," IEEE Electron Device Letters, Vol. 25, No. 11, Nov. 2004, pp. 731-733; and Takagi et al., "Comparative study of phonon-limited mobility of two-dimensional electrons in strained and unstrained Si metal-oxide-semiconductor field-effect transistors," Journal of Applied Physics, Vol. 80, No. 3, August, 1996, pp. 1567-1577. Many other techniques for straining a channel are known to those having skill in the art. From this modeling work, and experimental results reported in the literature, it has been found that the actual improvement in integrated circuit performance due to strain is generally nowhere near the improvements expected due to the measured mobility enhancement. For example, where the mobility enhancement may be known to be about 35%, the actual gain in performance, as measured by intrinsic gate delay, may be well under 20%. Moreover, the improvement in mobility may come at a price.

In particular, since the underlying physical effect is that of bandgap narrowing and band-edge shifting, several device characteristics generally are altered. The first, and possibly most significant effect, is on the mobility of the device, but there also may be a. significant effect on the $V_T$ of the device. The reduced bandgap and band shifting may alter the Fermi levels of the mobile carriers in the channel, leading to a reduced $V_T$ for both the *n* and *p*-channel devices. This $V_T$ shift can be on the order of 150-200 mV for biaxially tensile strained *n*-channel devices, and somewhat less for uniaxially strained devices. The reported $V_T$ shifts for *p*-channel devices are substantially less than for the *n*-channel devices and are generally ignored. Until recently, little attention had been paid to understanding the reasons for the $V_T$ shift. In order to compensate for the reduced $V_T$, higher dopings generally need to be used in the channel, lowering the mobility due to ionized impurity scattering and offsetting the strain-induced mobility enhancement. In addition, the higher dopings generally result in higher transverse fields.

Two other potentially detrimental effects due to the bandgap narrowing relate to the channel-to-source/drain junctions. Bandgap narrowing generally leads to increased junction leakage, which may be aggravated by the potential need for higher channel doping. In addition, the junction capacitance in the region of strain generally is increased, again aggravated by potentially higher dopings, which may reduce the dynamic performance of the device. All of these characteristics may combine to significantly degrade the benefits provided by the strain in conventional MOSFET designs.

## Channel-Strained, Gate-Engineered Fermi-FETs ,

As noted above, the use of $Si_{1-x}Ge_x$ gates for Fermi-FET designs may generally result in *n*-channel $V_T$ values which are too high. It may be desirable to find a method to reduce the $V_T$ of the device, apart from gate engineering. There is some latitude in the channel dopings, but for the most beneficial performance, the $V_T$ range may be fairly small. If $Si_{1-x}Ge_x$ is applied to the Fermi-FET gate, the use of an $Si_{1-y}Ge_y$ heterostructure channel may be beneficial, where *y* is used to differentiate the Ge content in the substrate from that used in the gate stack. After careful consideration, this indeed is the case for at least several reasons.

First is the $V_T$ shift resulting from the strained channel lattice. For a given set of *n*-channel Fermi-FET channel conditions, the application of strain can provide a shift in the negative direction, providing just about the right magnitude for an effective mid-bandgap work function shift with a $Si_{1-x}Ge_x$ gate. The amount of the $V_T$ shift may be dependent upon a number of factors. If a $Si_{1-y}Ge_y$ heterostructure is used to provide the strained channel, the amount of Ge (*y*) in the relaxed buffer layer can be a key factor. It has been shown in Fossum et al., cited above that, for biaxially strained Si, the $V_T$ shift can be expressed empirically as:

$$\Delta V_{T-SiGe} = E_{g(Si)} - E_{g(Si/SiGe)} = 0.4\, y\,(\text{eV})$$

which is expressed as the effective bandgap narrowing, with y being the fractional Ge content in the relaxed buffer. For practical Ge content values, e.g: $y$=0.20 at room temperature, the bandgap is reduced by about 80meV. For higher values, which provide higher mobility, such as $y$=0.50, the) $V_T$ could be around 200 mV. This is very close to the $V_T$ shift that is desired for the $Si_{1-x}Ge_x$ gate Fermi-FET. Note that the doping levels in a Fermi-FET structure are typically much lighter than a conventional surface-channel inversion (SCI) MOSFET. Thus, using a strained Si-on-SiGe channel structure, the *dopings may not need to be altered.* Thus, the Fermi-FET structure could be designed as if a true mid-bandgap work function were being used for the gate, with the desired $V_T$ shift arising from the combination of the $Si_{1-x}Ge_x$ gate stack and the Si-on-SiGe channel structure. Note that this effect on $V_T$ *is* considered a detractor for *n*-channel SCI MOSFETs and generally requires that conventional *n*-channel SCI MOSFETs use higher dopings. As noted earlier, the $V_T$ shift reported for *p*-channel SCI MOSFETs is nearly zero, and is expected to be nearly zero for *p*-channel Fermi-FETs as well.

Secondly, the strained Si channel can provide a significant enhancement in the mobilities of electrons and holes, although with different behaviors. Figure 2 graphically illustrates the reported mobility enhancements measured for both electrons and holes. The field value of 1.5 MV/cm illustrates a typical transverse field in an SCI MOSFET in the fully "on" state, with $V_{DS}=V_{GS}=V_{DD}$. The relative enhancement for electrons is near 80%, with a similar low-field value for holes. One point to note here is that the hole mobility has a much stronger field-dependent rolloffthan the electron mobility. At high transverse fields, e.g. above 1 MV/cm, the mobility enhancement nearly vanishes for holes, whereas the relative enhancement is maintained for electrons. The physical mechanism for this does not yet appear to be understood.

Since the Fermi-FET can be, by design, a lower-field/lower-doped structure, several potential benefits relative to the mobility enhancement can be seen by introducing strain into Fermi-FETs. First, for both *n* and *p*-channel Fermi-FETs, the lower surface fields in the "on" state can allow the devices to operate towards the regions in Fig. 1 where the *absolute* magnitude of the mobility is higher. Thus, the use of Fermi-FETs should in general provide a greater degree of enhancement than conventional SCI MOSFETs. More subtly, the *p*-channel Fermi-FET should provide an even greater *relative* enhancement than its SCI counterpart, due to the more dramatic *p*-channel mobility degradation with transverse field. This could lead to more significant overall CMOS performance enhancements than have been reported in the literature. It has been noted in the literature that most biaxially-stressed PMOS devices demonstrate near-zero hole mobility improvement at large vertical fields. See, Thompson et al., "A Logic Nanotechnology Featuring Strained Silicon", IEEE Electron Device Letters, Vol. 25, No. 4, April 2004, pp. 191-193. The lower vertical field of a Fermi-FET channel should have a significant effect on the *p*-channel mobility. Also note that the Fermi-FET generally results in lower doping levels, thus reduced mobility degradation due to ionized impurity scattering may result.

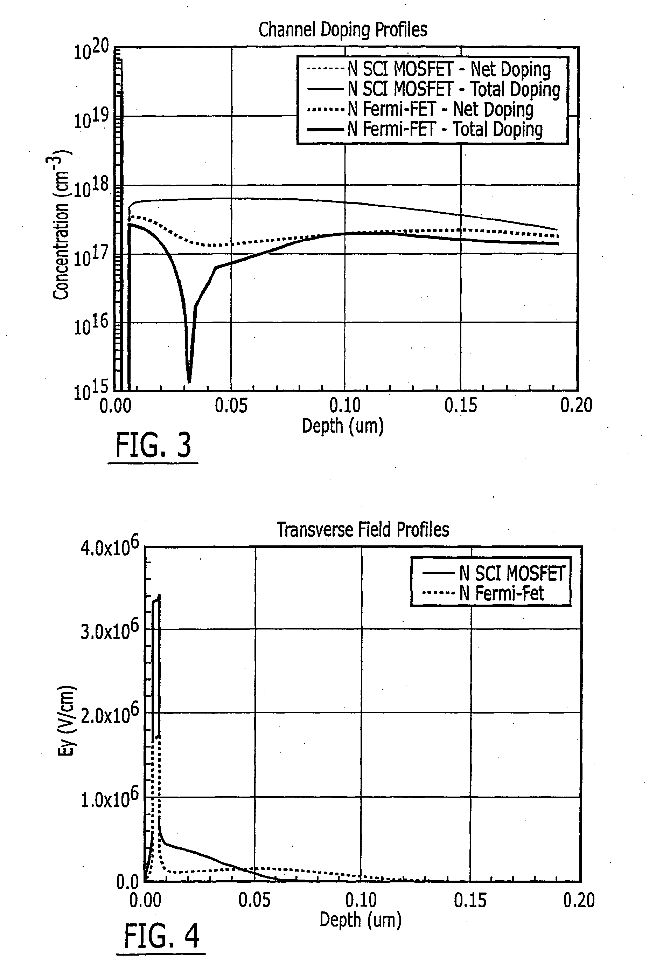

Figure 3 illustrates an example of channel doping profiles in the center of the channel for typical Fermi-FET and SCI MOSFET channel profiles. These devices are designed at $L_G$ = 0.18 $\mu$m, with identical oxide thicknesses and drain structures. For the case of the SCI MOSFET, the total and net doping curves are nearly identical and are indistinguishable, unlike the Fermi-FET. Note that the *total* doping curves appear to be the most relevant for discussing mobility degradation due to ionized impurity scattering. Comparing the Fermi-FET total doping to the SCI MOSFET, it can be seen that there is about a factor of two reduction in the total doping near the surface, which can have a significant positive effect on the mobility.

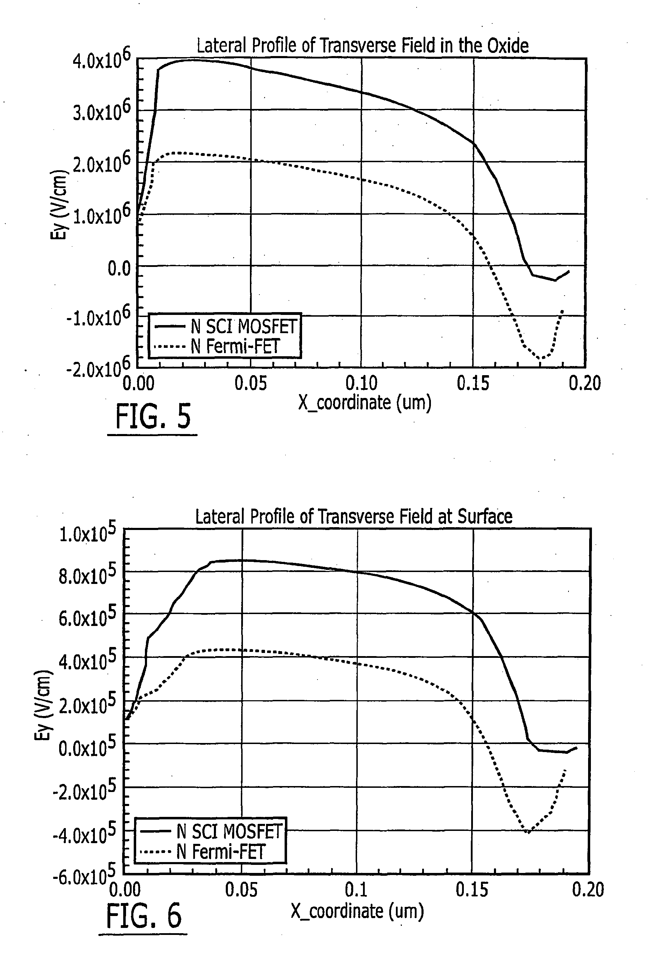

In order to illustrate the differences in field distribution ($E_y$) between conventional SCI MOSFETs and Fermi-FETs, Figures 4-6 show comparisons of the transverse electric field distributions. The same two sample SCI MOSFETs and Fermi-FETs are used as for Figure 3. Figure 4 is a plot of the transverse (vertical) field profile $E_y$ along the same vertical structure cutline as in Fig. 3 (the center of the channel) in the fully "on" state with $V_{GS}=V_{DS}=V_{DD}$. The reduction in surface field for the Fermi-FET can clearly be seen, as well as the oxide field reduction, which shows in the field spike near Depth=0. Figures 5 and 6 show the field distribution in the length (lateral or x) direction or direction of the channel, both in the oxide and at the silicon surface. In the oxide, the shape of the field distribution is virtually identical, but is offset in magnitude. Note however, that the transverse field $E_y$ in the silicon is similar at the source and drain ends of the channel, but is significantly lower in magnitude over the rest of the channel for the Fermi-FET. The Fermi-FET fields are seen to be generally about 2X lower than the SCI MOSFET fields up to the point of channel pinchoff. In the pinchoff region, the Fermi-FET field magnitude is higher, but is a *negative* value. This has a positive effect on device reliability. Often the Fermi-FET field in the pre-pinchoff region of the channel is even lower, which is related to the fact that a Fermi-FET design can have nearly *zero* field in the oxide and at the silicon surface at threshold ($V_{GS}=V_T$). The reduced field by design can provide for the Fermi-FET's improved mobility and capacitance characteristics.

As noted above, a Fermi-FET can have nearly zero vertical electric field in the oxide and at the silicon surface at threshold. For longer channel devices, where a one-dimensional analysis is valid, a vertical electric field of about 50 kV/cm or less may be provided. For short channel devices, where dopings are increased, oxide thickness is decreased, and other standard techniques may be used to reduce short channel effects, the fields may increase. Thus, for short channel devices, vertical electric fields on the order of about 100-200 kV/cm may be found at the threshold voltage. This is still a factor of about 2-5 below conventional SCI MOSFET devices. It should also be noted that Figures 4-6 show fields for devices in the fully "on" state, not at threshold. In a Fermi-FET, there would be little or no "supporting" field at threshold voltage, unlike an SCI MOSFET, which includes a built-in field because of the bulk charge which exists. Stated differently, the Fermi-FET provides a junction-depleted region, whereas an SCI MOSFET provides a gate-depleted region. Since the Fermi-FET provides a junction-depleted region, little or no gate field is needed at the threshold voltage.

From the considerations discussed above, Fermi-FET structures according to embodiments of the invention may be realized from the *combination of three architectural features* with the following characteristics:

1) $Si_{1-x}Ge_x$ gate stack (work function shift/reduced poly depletion);
2) Fermi-FET channel structure (low dopings and counter-doped meaning low-fields/low capacitances); and
3) Strained Si-on-SiGe substrate (enhanced mobility, additional $V_T$ shift - to compensate for $V_T$ from structure in 1 and 2 above).

Subcombinations of these architectural features also may be provided in other embodiments of the invention. In particular, features 1 and 2, 1 and 3, and 2 and 3 may be provided in other embodiments of the invention.

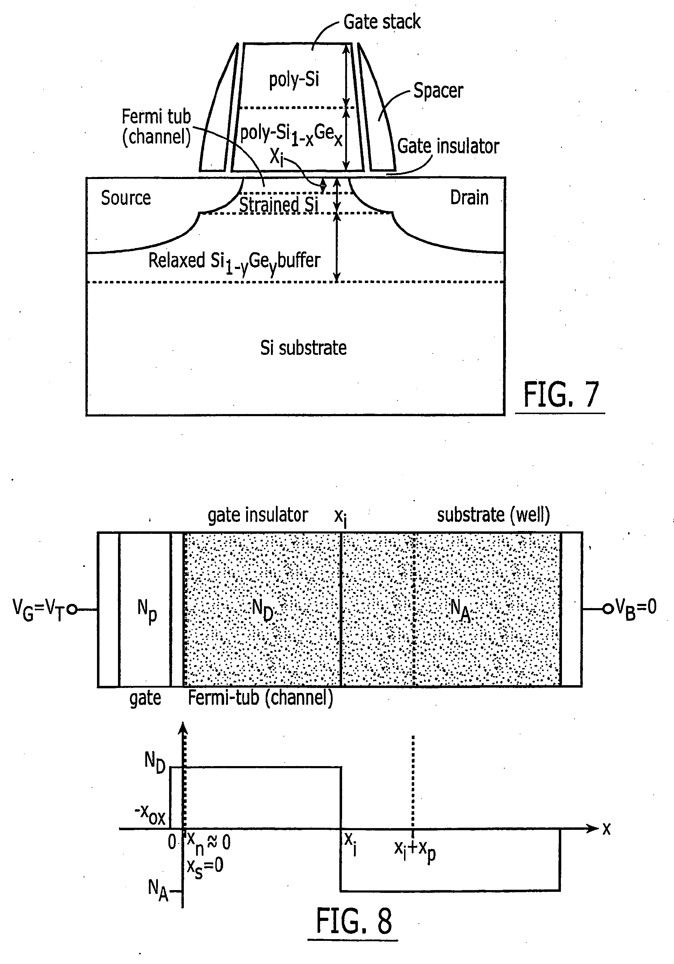

Figure 7 is a cross-sectional view of a strained Si-on-SiGe Fermi-FET according to exemplary embodiments of the present invention. This is merely a schematic, and the actual extents of the substrate, $Si_{1-y}Ge_y$ buffer and strained layer may vary. For an ideally-designed Fermi-FET, the channel dopings are as outlined in Figure 8. This is an expanded view of the channel region of the device in Figure 7; basically a one-dimensional picture of the channel profiles. Using the nomenclature defined in Figure 8, the dopings can satisfy the relationships discussed below to realize ideal Fermi-FET characteristics. Qualitatively, these characteristics include nearly zero field in the gate insulator and at the substrate surface at threshold. For illustrative purposes, an n-channel device is considered, and the analysis follows from a one-dimensional application of Poisson's equation relating charge and potential in the channel.

Referring to Figure 8, there can be three degrees of freedom or factors responsible for governing the channel potential and field distributions for a counter-doped structure such as the Fermi-FET. They are the Fermi-tub (or channel implant) net doping $N_D$, the underlying substrate (or well) net doping $N_A$ and the Fermi-tub junction depth (corresponding to the channel depth) $x_i$ as shown in Figure 8. The depletion region edges are shown as dashed lines at a bias condition of $V_G = V_T$. The silicon/oxide interface is defined as $x_s = 0$, and the substrate (well) bias $V_B = 0$. It can be shown by a solution of the 1-D Poisson's equation that the $V_T$ of this structure becomes the following,

$$V_T = V_{FB} + V_{bi}$$

where $V_{FB}$ is the well-known flatband voltage defined by the gate-to-substrate work-function difference $\Phi_{MS}$ and miscellaneous charges, which are assumed to be zero for this analysis. For a doped polysilicon gate, the work function difference can be expressed as the difference in Fermi levels between the gate and the substrate (well). $V_{bi}$ is the built-in voltage of the Fermi-tub to substrate junction and is defined as, $V_{bi} = v_{th} \ln\left[\dfrac{N_A N_D}{n_i^2}\right]$ with $v_{th} = \dfrac{kT}{q}$ or the well-known thermal voltage.

Note that the expression for $V_T$ has *no dependence upon gate oxide thickness* $x_{ox}$. This is indeed the case for an ideal Fermi-FET; the $V_T$ is *independent* of oxide thickness. A corollary feature is that the oxide and surface fields are *nearly zero* for the case pictured above. In order for this to be true, the three degrees of freedom satisfy the following relationship:

$$x_i = \frac{N_A}{N_D + N_A} \sqrt{\frac{2\varepsilon_s}{q}\left[\left[\frac{1}{N_A} + \frac{1}{N_D}\right]\right]},$$

where $x_i$ is the junction depth and is identical to the channel-side extent of the depletion region $x_n$. As in Figure 8, $N_A$ is the substrate (well) doping in cm$^{-3}$ and $N_D$ is the Fermi-tub (channel) doping in cm$^{-3}$. The other variables are the physical constants for the permittivity of the silicon or other substrate ($\varepsilon_s$) and elementary charge ($q$=1.6x10$^{-19}$ coulombs).

With the channel structure built this way, the $V_T$ is as defined above, and can be set solely by the gate-to-substrate work function, and the built-in voltage of the channel junction. Note that a unique solution for the condition above generally does not exist. Fixing any two of the factors $x_i$, $N_A$ or $N_D$ determines the third. Note that the gate work function may also be a function of the poly-Si gate doping. To reduce poly depletion effects and reduce series resistance, a poly-Si or poly-SiGe gate is usually very highly or degenerately doped, so the contribution of the poly-SiGe gate doping to the gate work function is not considered here.

Since this analysis is only 1-D, one might suspect that the behavior for very small geometries may differ, and indeed this may be the case. The influence of a strong drain field can alter the channel potential profile, hence the field distribution. The choices for $N_A$, $N_D$ and $x_i$ may not arbitrary then and may become constrained by the short-channel effects within the device. As device dimensions are reduced, in accordance with conventional scaling practices, dimensions such as $x_{ox}$ and $x_i$ may also need to be reduced in order to properly turn the device off. As the dimensions of $x_i$ and $x_{ox}$ shrink, the dopings $N_A$ and $N_D$ generally must both *increase* to keep the potential distributions, thus the electric fields within the device generally have the same shape. This is done to make sure the device can adequately turn off, and to increase or maximize the $I_{ON}/I_{OFF}$ ratio. Thus the dopings $N_A$ and $N_D$ generally cannot be made arbitrarily low for short-channel devices. Note, however that since the Fermi-FET structure, as shown in Figure 7 provides a built-in field, lighter dopings than a conventional surface inversion MOSFET are generally used for a given $x_{ox}$ and $x_i$. The final effect can be to significantly reduce the operational electric fields within the device, even for short-channel structures, compared with conventional surface inversion MOSFETs.

Note that, since the structure in Figure 7 can be epitaxially formed, an opportunity exists to create hyper-abrupt channel/well profiles, which the Fermi-FET can greatly benefit from. For example, with a selective epitaxial technique, it could be possible to provide a starting wafer with the Fermi-FET channel conditions pre-defined in the epi. A strained Si layer of about 20 nm could be in-situ doped to completely encompass the Fermi tub. A highly-doped substrate (well) could then be defined fully by the extent of the relaxed Si$_{1-y}$Ge$_y$ buffer layer, allowing a super-steep retrograde or hyper-abrupt channel structure to be formed. The Si substrate could be doped with a steep retrograde implanted well to prevent latchup and soft errors. With modem anneal tools, it would be possible to generate and maintain extremely sharp profiles, which may be generally desirable for very deep submicron device structures. To reiterate, this could use a photolithographically selective epitaxial process, where regions of epitaxial silicon could be grown with different doping levels and types, for example a phosphorous doped epi at a concentration of around 10$^{17}$ cm$^{-3}$ for the *n*-channel device, with a boron-doped epi grown also at a concentration of around 10$^{17}$ cm$^{-3}$ based upon conventional mask technology.

It may be possible to define much more symmetrical *n* and *p*-channel devices than is possible with implant-only process technology. The reason for this is that the commonly-used implant species diffuse at varying rates due to the physical mechanisms responsible for their diffusion. For example, it is well-known that boron, which could be used for a *p*-channel Fermi-FET Fermi-tub (channel) doping is a very rapid diffuser in silicon, thus making it difficult to control for defining thin, ultra-sharp profiles. Arsenic, on the other hand, which could be used for n-channel Fermi-FET Fermi-tub (channel) doping is much easier to control since it is a much heavier element and diffuses more slowly. If boron and arsenic were used for the *p*-channel and *n*-channel Fermi-FETs, respectively, the resulting channel profiles could be quite different, resulting in asymmetrical electrical performance. The use of the epitaxial technique described above could allow *p*-channel and *n*-channel Fermi-FETs with nearly identical extents and shapes, resulting in much more symmetrical electrical behavior.

Note that it has been recognized in Fossum et al., cited above, that the use of *p*+ poly-SiGe gate stacks can reduce gate depletion and boron penetration effects on conventional *p*-channel MOSFETs using a Si-on-SiGe channel structure. However, this discussion is focused on the *n*-channel device, and demonstrates how the combination of the *p*+ poly-SiGe gate stack and the Fermi-FET channel can provide further enhancements for the *n*-channel device, as well as the *p*-channel device.

Summary

The following equations may be used to design a Fermi-FET according to embodiments of the present invention.
The theoretical Fermi-FET channel expressions for the $V_T$ and the relationship among the dopings $N_A$, $N_D$ and $x_i$ are as follows:

$$V_T = V_{FB} + V_{bi}$$

where $V_{FB}=\Phi_{MS}$ and $V_{bi}=v_{th}\ln\left(\dfrac{N_A N_D}{n_i^2}\right)$ with $v_{th}=\dfrac{kT}{q}$ (the thermal voltage).

The dopings $N_A$ and $N_D$ can meet the following criterion:

$$x_i = \frac{N_A}{N_D+N_A}\sqrt{\frac{2\varepsilon_s}{q}\left[\left[\frac{1}{N_A}+\frac{1}{N_D}\right]\right]}$$

where $x_i$ is the depth of the $N_D$-side of the Fermi-tub (channel) junction as shown in Figure 8. Including the effects of the poly-Si$_{1-x}$Ge$_x$ gate and the Si-on-SiGe substrate, the net Fermi-FET threshold voltage $V_{TN}$ becomes:

$$V_{TN}=\Phi_{MS}+V_{bi}-\Delta V_{TG}-\Delta V_{TSUB}$$

where $\Delta V_{TG}$ is the shift in $V_T$ due to the poly-Si$_{1-x}$Ge$_x$ gate structure. Values for the Ge content $x$ in the poly-Si$_{1-x}$Ge$_x$ gate could be determined from data points as in Figure 1 to set $\Phi_{MS}$ or can come from experimental data. The term $\Delta V_{TSUB}$ is the additional shift in $V_T$ due to the Si$_{1-y}$Ge$_y$ substrate and can be defined empirically as:

$$\Delta V_{TSUB}=E_{g(Si)}-E_{g(Si/SiGe)}=0.4\,y$$

where y is the Ge content in the relaxed Si$_{1-y}$Ge$_y$ buffer layer.

<u>Example</u>

The following example is merely illustrative and shall not be construed as limiting the present invention. A long-channel device design is shown below. As discussed above, due to short-channel effects such as charge sharing, the final device threshold $V_{TN}$ may be somewhat lower than the long-channel value. The exact amount of this shift is generally extremely difficult to determine analytically and is generally dependent upon a large number of factors not considered in this discussion. The following expressions are used to determine the values in the design table:

$$V_{TN}=\Phi_{MS}+V_{bi}-\Delta V_{TG}-\Delta V_{TSUB}$$

$$\Phi_{MS}=\phi_{Gp}-\phi_{SUBp}$$

where

$$\phi_{Gp}=\frac{-kT}{q}\ln\left(\frac{N_{Apoly}}{n_i}\right)$$

where $N_{Apoly}$ is the poly gate doping

$$\phi_{SUBp}=\frac{-kT}{q}\ln\left(\frac{N_A}{n_i}\right)$$

$$V_{bi} = \frac{kT}{q} \ln\left(\frac{N_A N_D}{n_i^2}\right)$$

$$\Delta V_{TSUB} = E_{g(Si)} - E_{g(Si/SiGe)} = 0.4\, y$$

$\Delta V_{TG}$ from experimental data assumed to be 0.4 V

| Parameter | Description | Value |
|---|---|---|
| $N_A$ | Substrate doping | $10^{18}$ cm$^{-3}$ |
| $N_D$ | Fermi-tub doping | $10^{17}$ cm$^{-3}$ |
| $x_i$ | Fermi-tub depth | 0.109 $\mu$m |
| $x$ | Gate Ge content | 70.00% |
| $y$ | Substrate Ge content | 40.00% |
| $\Delta V_{TSUB}$ | $V_T$ shift due to Si-on-SiGe substrate | 0.16V |
| $\Delta V_{TG}$ | $V_T$ shift due to poly-Si$_{1-x}$Ge$_x$ gate stack | 0.40 V |
| $V_{TN}$ | Final device $V_T$ | 0.398 V |

## Conclusions

It has been shown herein that the facts that higher dopings generally are used for both *n* and *p*-channel MOSFET devices, and that the *p*-channel devices do not enjoy the same relative enhancement as the *n*-channel devices, may combine to significantly reduce the actual performance of strained Si-on-SiGe circuits. In addition, due to the generally higher dopings, and the bandgap reduction, junction capacitances in the strain layer generally are higher, further reducing performance. In practice, performance gains of no more than 20-25% may be seen.

In contrast, the fact that lighter dopings are typically used in Fermi-FETs, and the transverse surface fields are typically much lower than in SCI devices can combine to allow the Fermi-FET to enjoy significantly more benefit from strained-Si mobility enhancement, as well as two more potential advantages: a greater degree of relative hole mobility enhancement for the *p*-channel Fermi-FETs, and the capability to use SiGe gate stack technology for the *n*-channel Fermi-FET due to the $V_T$ shift. Concerning the previously discussed potential disadvantages, since the Fermi-FET device design usually uses lower dopings, the impact on leakage current and capacitance can be reduced as well, compared with conventional SCI MOSFETs.

The present invention has been described herein with reference to the accompanying drawings, in which exemplary embodiments of the invention are shown. However, this invention should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Moreover, each embodiment described and illustrated herein includes its complementary conductivity type embodiment as well. Like numbers refer to like elements throughout

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will also be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

The terminology used in the description of the invention herein is for the purpose of describing particular embodiments only and is not intended to be limiting of the invention. As used in the description of the invention and the appended claims, the singular forms "a", "an " and "the" are intended to include the plural forms as well, unless the context clearly indicates otherwise. It will also be understood that the term "and/or" as used herein refers to and encompasses any and all possible combinations of one or more of the associated listed items and may be abbreviated as "/".

Embodiments of the invention were described herein with reference to illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. The regions illustrated in the figures are schematic in nature and their shapes are not intended to illustrate the actual shape of a region of a device and are not intended to limit the scope of the invention.

Unless otherwise defined, all terms used in disclosing embodiments of the invention, including technical and scientific terms, have the same meaning as commonly understood by one of ordinary skill in the art to which this invention belongs, and are not necessarily limited to the specific definitions known at the time of the present invention being described. Accordingly, these terms can include equivalent terms that are created after such time.

In the drawings and specification, there have been disclosed embodiments of the invention and, although specific terms are employed, they are used in a generic and descriptive sense only and not for purposes of limitation, the scope of the invention being set forth in the following claims.

## Claims

1. A field effect transistor comprising:

    a silicon channel in a substrate;
    source/drain regions in the substrate at opposite ends of the strained silicon channel;
    a gate insulating layer on the strained silicon channel; and
    a gate on the gate insulating layer that is configured to provide a gate work function that is close to a mid-bandgap of silicon, **characterised in that** the silicon channel
    is strained.

2. A field effect transistor according to Claim 1 further comprising:

    a relaxed silicon-germanium buffer layer between the substrate and the strained silicon channel that is configured to apply strain to the strained silicon channel.

3. A field effect transistor according to Claim 1 wherein the gate comprises polysilicon-germanium.

4. A field effect transistor according to Claim 3 wherein the gate further comprises a polysilicon layer on the polysilicon-germanium remote from the gate insulating layer.

5. A field effect transistor according to Claim 1 wherein the gate is configured to provide a gate work function that is within about 0.3 eV of the mid-bandgap of silicon.

6. A field effect transistor according to Claim I wherein the gate is configured to provide a gate work function of about 4.7eV.

7. A field effect transistor according to Claim 1 wherein doping of the strained silicon channel, doping of the substrate and/or a depth of the strained silicon channel are configured to produce nearly zero vertical electric field in the gate insulating layer and in the strained silicon channel adjacent thereto at a threshold voltage of the field effect transistor.

**8.** A field effect transistor according to Claim 7 further comprising:

a relaxed silicon-germanium buffer layer between the substrate and the strained silicon channel that is configured to apply strain to the strained silicon channel.

**9.** A field effect transistor according to Claim 7 wherein the gate comprises polysilicon-germanium,

**10.** A field effect transistor according to Claim 9 wherein the gate further comprises a polysilicon layer on the polysilicon-germanium remote from the gate insulating layer.

**11.** A field effect transistor according to Claim 7 wherein the gate is configured to provide a gate work function that is within about 0.3 eV of the mid-bandgap of silicon.

**12.** A field effect transistor according to Claim 7 wherein the gate is configured to provide a gate work function of about 4,7 eV.

**13.** A field effect transistor according to Claim 7 wherein the doping of the channel, the doping of the substrate and/or the depth of the channel are selected according to:

$$x_i = \frac{N_A}{N_D + N_A} \sqrt{\frac{2\varepsilon_s}{q} \left[\left[ \frac{1}{N_A} + \frac{1}{N_D} \right]\right]}$$

wherein $x_i$ is the depth of the channel, $N_A$ is the substrate doping $N_D$ is the channel doping, $\varepsilon_s$ is the permittivity of silicon and $q$ is the elementary charge.

**14.** A method of fabricating a field effect transistor comprising:

epitaxially growing a relaxed silicon-germanium buffer layer on a silicon substrate;
epitaxially growing a strained silicon channel on the relaxed silicon-germanium buffer layer;
forming source/drain regions in the substrate at opposite ends of the strained silicon channel;
forming a gate insulating layer on the strained silicon channel, wherein doping of the strained silicon channel, doping of the substrate and/or a depth of the strained silicon channel are configured to produce nearly zero vertical electric field in the gate insulating layer and in the
strained silicon channel adjacent thereto at a threshold voltage of the field effect transistor; and
forming a gate on the gate insulating layer that is configured to provide a gate work function that is close to a mid-bandgap of silicon.

**15.** A method according to Claim 14 wherein forming source/drain regions comprises selectively epitaxially growing the source/drain regions during the epitaxially growing of the relaxed silicon-germanium buffer layer and/or the epitaxially growing of the strained silicon channel.

**Patentansprüche**

**1.** Feldeffekttransistor, umfassend:

einen Silicium-Kanal in einem Substrat;
Source/Drain-Bereiche in dem Substrat an gegenüberliegenden Enden des verspannten Silicium-Kanals;
eine Gate-Isolierschicht auf dem verspannten Silicium-Kanal; und
ein Gate auf der Gate-Isolierschicht, das dafür konfiguriert ist, eine Gate-Austrittsarbeit zu leisten, die nahe einer Mitte der Bandlücke von Silicium liegt, **dadurch gekennzeichnet, dass** der Silicium-Kanal verspannt ist.

**2.** Feldeffekttransistor nach Anspruch 1, ferner umfassend:

eine entspannte Silicium-Germanium-Pufferschicht zwischen dem Substrat und dem verspannten Silicium-Kanal, die dafür konfiguriert ist, Spannung auf den verspannten Silicium-Kanal auszuüben.

3. Feldeffekttransistor nach Anspruch 1, wobei das Gate Polysilicium-Germanium aufweist.

4. Feldeffekttransistor nach Anspruch 3, wobei das Gate ferner eine Polysiliciumschicht auf dem Polysilicium-Germanium fern von der Gate-Isolierschicht aufweist.

5. Feldeffekttransistor nach Anspruch 1, wobei das Gate dafür konfiguriert ist, eine Gate-Austrittsarbeit zu leisten, die innerhalb von etwa 0,3 eV der Mitte der Bandlücke von Silicium liegt.

6. Feldeffekttransistor nach Anspruch 1, wobei das Gate dafür konfiguriert ist, um eine Gate-Austrittsarbeit von etwa 4,7 eV zu leisten.

7. Feldeffekttransistor nach Anspruch 1, wobei die Dotierung des verspannten Silicium-Kanals, die Dotierung des Substrats und/oder eine Tiefe des verspannten Silicium-Kanals dafür konfiguriert sind, in der Gate-Isolierschicht und in dem an diese angrenzenden verspannten Silicium-Kanal bei einer Schwellspannung des Feldeffekttransistors ein vertikales elektrisches Feld von nahezu Null zu erzeugen.

8. Feldeffekttransistor nach Anspruch 7, ferner umfassend:

eine entspannte Silicium-Germanium-Pufferschicht zwischen dem Substrat und dem verspannten Silicium-Kanal, die dafür konfiguriert ist, Spannung auf den verspannten Silicium-Kanal auszuüben.

9. Feldeffekttransistor nach Anspruch 7, wobei das Gate Polysilicium-Germanium aufweist.

10. Feldeffekttransistor nach Anspruch 9, wobei das Gate ferner eine Polysiliciumschicht auf dem Polysilicium-Germanium fern von der Gate-Isolierschicht aufweist.

11. Feldeffekttransistor nach Anspruch 7, wobei das Gate dafür konfiguriert ist, Gate-Austrittsarbeit zu leisten, die innerhalb von etwa 0,3 eV der Mitte der Bandlücke von Silicium liegt.

12. Feldeffekttransistor nach Anspruch 7, wobei das Gate dafür konfiguriert ist, Gate-Austrittsarbeit von etwa 4,7 eV zu leisten.

13. Feldeffekttransistor nach Anspruch 7, wobei die Dotierung des Kanals, die Dotierung des Substrats und/oder die Tiefe des Kanals folgendermaßen gewählt sind:

$$x_i = \frac{N_A}{N_D + N_A} \sqrt{\frac{2\varepsilon_s}{q} \left[ \left[ \frac{1}{N_A} + \frac{1}{N_D} \right] \right]}$$

wobei $x_i$ die Tiefe des Kanals, $N_A$ die Substratdotierung, $N_D$ die Kanaldotierung, $\varepsilon_s$ die Dielektrizitätskonstante von Silicium und $q$ die Elementarladung ist;

14. Verfahren zur Herstellung eines Feldeffekttransistors, umfassend:

epitaxiales Aufwachsen einer entspannten Silicium-Germanium-Pufferschicht auf einem Siliciumsubstrat;
epitaxiales Aufwachsen eines verspannten Silicium-Kanals auf der entspannten Silicium-Germanium-Pufferschicht;
Ausbilden von Source/Drain-Bereichen in dem Substrat an gegenüberliegenden Enden des verspannten Silicium-Kanals;
Ausbilden einer Gate-Isolierschicht auf dem verspannten Silicium-Kanal, wobei die Dotierung des verspannten Silicium-Kanals, die Dotierung des Substrats und/oder eine Tiefe des verspannten Silicium-Kanals dafür konfiguriert sind, in der Gate-Isolierschicht und in dem an diese angrenzenden verspannten Silicium-Kanal bei einer Schwellspannung des Feldeffekttransistors ein vertikales elektrisches Feld von nahezu Null zu erzeugen; und
Ausbilden eines Gates auf der Gate-Isolierschicht, das dafür konfiguriert ist, eine Gate-Austrittsarbeit zu leisten, die nahe an einer Mitte der Bandlücke von Silicium liegt.

**15.** Verfahren nach Anspruch 14, wobei die Ausbildung von Source/Drain-Bereichen selektives epitaxiales Aufwachsen der Source/Drain-Bereiche während des epitaxialen Aufwachsens der entspannten Silicium-Germanium-Pufferschicht und/oder des epitaxialen Aufwachsens des verspannten Silicium-Kanals umfasst.

**Revendications**

**1.** Transistor à effet de champ comprenant :

un canal de silicium dans un substrat ;
des régions de source/drain dans le substrat à des extrémités opposées du canal de silicium contraint ;
une couche d'isolation de grille sur le canal de silicium contraint ; et
une grille sur la couche d'isolation de grille qui est configurée pour remplir une fonction de travail de sortie de grille qui est proche du centre de la bande interdite du silicium, **caractérisé en ce que** le canal de silicium est contraint.

**2.** Transistor à effet de champ selon la revendication 1 comprenant en outre :

une couche tampon de silicium-germanium entre le substrat et le canal de silicium contraint qui est configurée pour appliquer une contrainte au canal de silicium contraint.

**3.** Transistor à effet de champ selon la revendication 1 dans lequel la grille comprend du polysilicium-germanium.

**4.** Transistor à effet de champ selon la revendication 3 dans lequel la grille comprend en outre une couche de polysilicium sur le polysilicium-germanium distant de la couche d'isolation de grille.

**5.** Transistor à effet de champ selon la revendication 1 dans lequel la grille est configurée pour produire une fonction de travail de sortie de grille qui est à environ 0,3 eV du centre de la bande interdite du silicium.

**6.** Transistor à effet de champ selon la revendication 1 dans lequel la grille est configurée pour produire une fonction de travail de sortie de grille d'environ 4,7 eV.

**7.** Transistor à effet de champ selon la revendication 1 dans lequel le dopage du canal de silicium contraint, le dopage du substrat et/ou la profondeur du canal de silicium contraint sont configurés pour produire un champ électrique vertical proche de zéro dans la couche d'isolation de grille et dans le canal de silicium contraint adjacent à celui-ci à une tension de seuil du transistor à effet de champ.

**8.** Transistor à effet de champ selon la revendication 7 comprenant en outre :

une couche tampon de silicium-germanium relaxé entre le substrat et le canal de silicium contraint qui est configurée pour appliquer une contrainte au canal de silicium contraint.

**9.** Transistor à effet de champ selon la revendication 7 dans lequel la grille comprend du polysilicium-germanium.

**10.** Transistor à effet de champ selon la revendication 9 dans lequel la grille comprend une couche de polysilicium sur le polysilicium-germanium distant de la couche d'isolation de grille.

**11.** Transistor à effet de champ selon la revendication 7 dans lequel la grille est configurée pour produire une fonction de travail de sortie de grille qui est à environ 0,3 eV du centre de la bande interdite du silicium.

**12.** Transistor à effet de champ selon la revendication 7 dans lequel la grille est configurée pour produire une fonction de travail de sortie de grille d'environ 4,7 eV.

**13.** Transistor à effet de champ selon la revendication 7 dans lequel le dopage du canal, le dopage du substrat et/ou la profondeur du canal sont choisis selon :

$$x_i = \frac{N_A}{N_D + N_A} \sqrt{\frac{2\varepsilon_s}{q}\left[\left[\frac{1}{N_A} + \frac{1}{N_D}\right]\right]}$$

où $x_i$ est la profondeur du canal, $N_A$ est le dopage de substrat, $N_D$ est le dopage de canal, $\varepsilon_s$ est la permittivité du silicium et $q$ est la charge élémentaire.

14. Procédé de fabrication d'un transistor à effet de champ comprenant :

la croissance épitaxiale d'une couche tampon de silicium-germanium sur un substrat de silicium ;
la croissance épitaxiale d'un canal de silicium contraint sur la couche tampon de silicium-germanium relaxé ;
la formation de régions de source/drain dans le substrat aux extrémités opposées du canal de silicium contraint ;
la formation d'une couche d'isolation de grille sur le canal de silicium contraint, où le dopage du canal de silicium contraint, le dopage du substrat et/ou la profondeur du canal de silicium contraint sont configurés pour produire un champ électrique vertical proche de zéro dans la couche d'isolation de grille et dans le canal de silicium contraint adjacent à celui-ci à une tension de seuil du transistor à effet de champ ; et
la formation d'une grille sur la couche d'isolation de grille qui est configurée pour produire une fonction de travail de sortie de grille qui est proche du centre de la bande interdite du silicium.

15. Procédé selon la revendication 14 dans lequel la formation des régions de source/drain comprend la croissance épitaxiale sélective des régions de source/drain pendant la croissance épitaxiale de la couche tampon de silicium-germanium relaxée et/ou la croissance épitaxiale du canal de silicium contraint.

FIG. 1

FIG. 2

## Channel Doping Profiles

FIG. 3

## Transverse Field Profiles

FIG. 4

Lateral Profile of Transverse Field in the Oxide

FIG. 5

Lateral Profile of Transverse Field at Surface

FIG. 6

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4984043 A
- US 4990974 A
- US 5151759 A
- US 5194923 A
- US 5222039 A
- US 5367186 A
- US 5369295 A
- US 5371396 A
- US 5374836 A
- US 5438007 A

- US 5440160 A
- US 5525822 A
- US 5543654 A
- US 5698884 A
- US 5786620 A
- US 5814869 A
- US 5885876 A
- US 6555872 A
- US 5952701 A

### Non-patent literature cited in the description

- **Hellberg et al.** Work Function of Boron-Doped Polycrystalline SixGe1-x Films. *IEEE Electron Device Letters,* September 1997, vol. 18 (9), 456-458
- **Fossum et al.** Performance Projections of Scaled CMOS Devices and Circuits With Strained Si-on-SiGe Channels. *IEEE Transactions on Electron Devices,* April 2003, vol. 50 (4), 1042-1049
- **Miyata et al.** Electron transport properties of a strained Si layer on a relaxed Si1-xGex substrate by Monte Carlo simulation. *Applied Physics Letters,* May 1993, vol. 62 (21), 2661-2663
- **Goo et al.** Scalability of Strained-Si nMOSFETs Down to 25 nm Gate Length. *IEEE Electron Device Letters,* May 2003, vol. 24 (5), 351-353

- **Lim et al.** Comparison of Threshold-Voltage Shifts for Uniaxial and Biaxial Tensile-Stressed n-MOSFETs. *IEEE Electron Device Letters,* November 2004, vol. 25 (11), 731-733
- **Takagi et al.** Comparative study of phonon-limited mobility of two-dimensional electrons in strained and unstrained Si metal-oxide-semiconductor field-effect transistors. *Journal of Applied Physics,* August 1996, vol. 80 (3), 1567-1577
- **Thompson et al.** A Logic Nanotechnology Featuring Strained Silicon. *IEEE Electron Device Letters,* April 2004, vol. 25 (4), 191-193